Europäisches Patentamt

(19) European Patent Office

Office européen des brevets

(11) Veröffentlichungsnummer: **0 006 510**
B1

(12) EUROPÄISCHE PATENTSCHRIFT

(45) Veröffentlichungstag der Patentschrift:
13.04.83

(51) Int. Cl.³: **H 01 L 21/18, H 01 L 21/316,**
**H 01 L 29/08**

(21) Anmeldenummer: 79101845.0

(22) Anmeldetag: 11.06.79

(54) Verfahren zum Erzeugen aneinander grenzender, unterschiedlich dotierter Siliciumbereiche.

(30) Priorität: 30.06.78 US 920924

(43) Veröffentlichungstag der Anmeldung:
09.01.80 Patentblatt 80/1

(45) Bekanntmachung des Hinweises auf die Patenterteilung:
13.04.83 Patentblatt 83/15

(84) Benannte Vertragsstaaten:
DE FR GB

(56) Entgegenhaltungen:
FR-A-2 006 784
US-A-3 398 029
US-A-3 886 004
US-A-3 899 372
US-A-3 986 896
US-A-4 007 103
US-A-4 049 477
IBM TECHNICAL DISCLOSURE BULLETIN, Vol. 20, Oktober 1977, New York, US, B. M. KEMLAGE: »Process for selfaligned subisolation diffusions«, Seiten 1751—1752

(73) Patentinhaber: International Business Machines Corporation, Armonk, N.Y. 10504 (US)

(72) Erfinder: Goth, George Richard, RD No.2 Todd Hill Road, Poughkeepsie, NY 12603 (US)

(74) Vertreter: Oechssler, Dietrich, Dr.rer.nat. Dipl.-Chem., Schönaicher Strasse 220, D-7030 Böblingen (DE)

## Verfahren zum Erzeugen aneinandergrenzender, unterschiedlich dotierter Siliciumbereiche

Die Erfindung betrifft ein Verfahren, welches im Oberbegriff des Anspruchs 1 definiert ist und die Verwendung eines solchen Verfahrens.

Die Bildung von verschiedenen dotierten Bereichen in einem Halbleiterchip, welche zur Herstellung von Transistoren, Dioden, Widerständen usw. in integrierten Schaltungen benötigt werden, erfordert eine sehr genaue Positionierung. Dazu ist es erforderlich, daß die Ausrichtung von aufeinanderfolgenden lithographischen Masken, welche zur Herstellung der mit Verunreinigungen dotierten Bereichen benutzt werden, zueinander sehr genau ist. Komplexe Strukturen, wie z. B. bipolare und fortgeschrittene Feldeffekt-Transistoren enthaltende integrierte Schaltungen erfordern eine große Anzahl von Maskierungsschritten. Wie gut die aufeinanderfolgenden Maskierungsoperationen durchgeführt werden können, hängt in starkem Maß von der Genauigkeit der vorangegangenen Maskierungsschritte ab.

Der zugelassene Abstand zwischen den Öffnungen in lithographischen Masken muß so groß sein, daß eine geringe Maskenfehljustierung, eine fehlerhafte Größe der Öffnung, ein geringes Überätzen usw. verkraftet werden können. Dieser Abstand wird sehr kritisch, wenn die Anzahl von Masken zunimmt. Durch diese zuzulassende Toleranz wird Platz vergeudet, so daß die Packungsdichte der Schaltungselemente auf dem Substrat geringer wird.

Üblicherweise werden genau festgelegte dotierte Bereiche, welche zueinander ausgerichtet sind, in einem Substrat in der folgenden Weise hergestellt: Zuerst wird auf dem Substrat eine Maskenschicht, beispielsweise aus Siliciumdioxid, erzeugt. Auf dieser Maskenschicht wird eine Schicht aus einem strahlungsempfindlichen Lack aufgebracht, welche anschließend selektiv belichtet und dann entwickelt wird, um auf diese Weise ein Muster mit den lateralen Abmessungen der ersten zu dotierenden Bereiche zu erzeugen. Die Photolackmaske dient beim anschließenden Ätzen der Siliciumdioxidschicht als Ätzmaske. Bei diesem Ätzen werden Fenster in die Siliciumdioxidschicht bis hinunter zum Substrat erzeugt. Durch diese Fenster im Siliciumdioxid werden dann Verunreinigungen in das Substrat eingeführt, wobei dann erste dotierte Bereiche entstehen. Um die anderen dotierten Bereiche zu erzeugen, wird das Substrat im allgemeinen neu oxidiert, und anschließend wird wie oben beschrieben weiter verfahren, um die anderen dotierten Bereiche zu erzeugen. Diese bekannten Verfahren benötigen bei jedem Verfahrensschritt, bei welchem eine festgelegte Verunreinigung, sei es mittels Diffusion oder mittels Ionenimplantation, in das Substrat eingeführt wird, eine genau ausgerichtete lithographische Maske. Das ist sehr teuer sowohl bezüglich der Maskenkosten als auch bezüglich der Ausbeuteverluste, welche bei der Produktion infolge des komplizierten Verfahrens in Kauf genommen werden müssen. Jede beachtliche Fehljustierung einer zweiten Maske bezüglich einer ersten Maske hat im allgemeinen ein defektes Plättchen zur Folge, wobei ein solches Plättchen aus hunderten von einzelnen Chips besteht.

Andere, neuere Verfahren zur Herstellung festgelegter, ausgerichteter dotierter Bereiche arbeiten mit Diffusionsmasken, welche bezüglich einander selektiv ätzbar sind. Beispielsweise werden Siliciumdioxid und Siliciumnitrid von gepufferter Flußsäure bzw. von heißer Phosphorsäure geätzt, während die gepufferte Flußsäure Siliciumnitrid und die heiße Phosphorsäure das Siliciumdioxid nicht wesentlich angreifen.

Typischerweise wird das Nitrid auf der Oxidschicht, welche die Substratoberfläche bedeckt, abgeschieden. Eine einzige Lackmaske und konventionelle lithographische Ätztechniken, mittels derer das Siliciumnitrid selektiv entfernt wird, werden dann dazu benützt, um in einem einzigen Schritt beide Sätze von festgelegten, zu dotierenden Bereichen zu definieren. Als nächstes wird eine andere Photolackmaske, welche bezüglich ihrer Ausrichtung unkritisch ist und im allgemeinen als Blockiermaske (blocking mask) bezeichnet wird, erzeugt, indem wieder eine Photolackschicht aufgebracht, belichtet und entwickelt wird, wobei dann diejenigen Teile der Siliciumdioxidschicht freigelegt werden, welche sich über denjenigen Stellen befinden, an denen der erste Satz von dotierten Bereichen erzeugt werden soll. Die Siliciumdioxidschicht wird mit gepufferter Flußsäure selektiv geätzt, wobei die Siliciumnitridschicht als die die Öffnungen im Siliciumoxid definierende Maske wirkt. Dann wird der erste Satz von dotierten Bereichen erzeugt, indem die Verunreinigungen in das Substrat durch die Öffnungen in der Siliciumdioxidschicht eingeführt werden. Anschließend wird eine zweite Blockiermaske erzeugt, welche den ersten Satz von dotierten Bereichen abdeckt und das Siliciumdioxid über den Stellen, an denen der zweite Satz von dotierten Bereichen erzeugt werden soll, freiläßt; dann wird das freiliegende Siliciumdioxid weggeätzt und schließlich der zweite Satz von dotierten Bereichen, wie oben beschrieben, erzeugt. Dieses verbesserte Verfahren und auch Variationen dieses Verfahrens, bei denen kritisch ausgerichtete Lackmasken nicht erforderlich sind, brauchen doch die Anwendung von voneinander getrennten lithographischen Maskenschritten für die Bildung eines jeden einzelnen Satzes von dotierten Bereichen.

Eine aus einer Siliciumdioxid- und einer Siliciumnitridschicht bestehende Maske verwendet auch ein im IBM-Technical Disclosure Bulletin, Bd. 20, Nr. 5, Oktober 1977, Seite 1751, veröffentlichtes Verfahren, bei dem zunächst unter Verwendung der genannten Maske Bereiche des ersten Leitfähigkeitstyps und anschließend nach einer gezielten Unterätzung der Siliciumnitridschicht, dem Aufwachsen einer relativ dicken Oxidschicht und dem vollständigen Entfernen der ursprünglichen Maske Bereiche eines zweiten Leitfähigkeitstyps erzeugt werden.

Aus der letztgenannten Literaturstelle sind die im ersten Teil des Anspruchs 1 angegebenen Maßnahmen bei einem Verfahren zum Erzeugen in einem Siliciumsubstrat einander benachbarter, unterschiedlich dotierter Bereiche bekannt.

Eine andere Technik, welche zur Bildung von festgelegten, zueinander ausgerichteten dotierten Bereichen angegeben worden ist, beinhaltet die Anwendung einer Diffusionsmaskenschicht, welche typischerweise aus Siliciumdioxid besteht und welche Bereiche unterschiedlicher Dicke aufweist. Eine solche Technik ist beispielsweise in dem Artikel von C. H. Lee mit dem Titel »Self-Aligning Subcollector and Isolation Regions in a Semiconductor Transistor«, welcher im IBM Technical Disclosure Bulletin, Band 20, Nr. 6, November 1977, auf den Seiten 2233 und 2234 erschienen ist, beschrieben. Diese Technik ähnelt dem oben angegebenen, selektiv ätzbare Maskenschichten anwendenden Verfahren insofern, als auch bei dem in dem IBM Technical Disclosure Bulletin beschriebenen Verfahren nacheinander aufzubringende photolithographische Masken erforderlich sind. Allerdings ist auch bei dem zuletzt genannten Verfahren eine sehr genaue Ausrichtung der einzelnen Masken zueinander nicht erforderlich.

Die oben angegebenen Verfahren sind dazu benutzt worden, um verschiedene Typen von dotierten Bereichen herzustellen. Sie sind auch in den Fällen eingesetzt worden, in denen zwei hochdotierte, einander benachbarte Bereiche, wie z. B. der Subkollektor- und der Isolationsbereich eines bipolaren Transistors, herzustellen sind. Es ist notwendig, daß solche Bereiche nicht übermäßig überlappen, weil sonst innerhalb der Bereiche Versetzungen auftreten. Diese Probleme können vermieden werden, indem die Masken so ausgelegt werden, daß die Bereiche größere Abstände voneinander haben. Allerdings wird dabei die Packungsdichte in der Schaltung reduziert. Alternativ können die Versetzungen auch einfach in Kauf genommen werden, wobei es dann allerdings so ist, daß die Menge von brauchbaren Chips in Abhängigkeit von der statistischen Verteilung der Versetzungen und ihres Einflusses auf die Funktionsfähigkeit der Chips reduziert wird.

Es ist die Aufgabe der Erfindung, ein Verfahren zum reproduzierbaren Erzeugen von unterschiedlich dotierten Siliciumbereichen, welche zueinander ausgerichtet sind und aneinandergrenzen, bei dem möglichst wenig photolithographische Schritte angewandt werden müssen und bei dem die Dotierungskonzentrationen im Überlappungsbereich genau definiert und an keiner Stelle gleich der maximalen Oberflächenkonzentration sind und Verwendungen eines solchen Verfahrens anzugeben.

Diese Aufgabe wird mit einem Verfahren der eingangs genannten Art mit den Merkmalen des kennzeichnenden Teils des Anspruchs 1 und durch die Verwendung des beanspruchten Verfahrens gemäß dem Patentanspruch 12 gelöst. Der Stand der Technik, von dem der Oberbegriff des Patentanspruchs 1 ausgeht, ist in Spalte 3 im 3. Absatz beschrieben.

Mit dem erfindungsgemäßen Verfahren wird die Herstellung von zueinander ausgerichteten dotierten Bereichen innerhalb eines Halbleitersubstrats verbessert und vereinfacht. Oft wird zur Erzeugung des ersten dotierten Bereiches, nicht aber zur Erzeugung des zweiten, eine auf photolithographischem Weg erzeugte Dotierungsmaske benötigt, d. h. mit anderen Worten, daß weniger Photomasken benötigt werden als bei den bekannten Verfahren. Dadurch erhält man nicht nur eine wesentliche Reduzierung des Arbeitsaufwandes, vielmehr werden auch die bei Anwendung der bekannten Verfahren auftretenden, durch Fehljustierungen aufeinanderfolgender Photomasken zueinander verursachten Ausfälle reduziert. Überraschenderweise lassen sich mit dem erfindungsgemäßen Verfahren die Konzentrationen der Verunreinigungen im Überlappungsbereich der Bereiche erster und zweiter Art sehr genau kontrollieren, was offenbar auf die Selbstjustierung der Dotierungsmaske für das Dotieren der zweiten Bereiche zurückzuführen ist. Auf diese Weise kann vermieden werden, daß im Überlappungsbereich die Konzentrationen der beiden Verunreinigungen maximal sind, so daß einerseits die Bildung von Versetzungen in den Bereichen auf ein Minimum reduziert werden kann und andererseits die Abstände, welche eingehalten werden müssen, um ein Überlappen der Bereiche maximaler Konzentration in jedem Fall zu verhindern und welche bei den bekannten Verfahren beachtlich groß sind, sehr stark reduziert werden können, so daß sich die Packungsdichte beachtlich erhöhen läßt.

Das erfindungsgemäße Verfahren beruht im wesentlichen darauf, daß die Geschwindigkeit, mit der Silicium oxidiert wird, um so höher ist, je höher dotiert das Silicium mit den N-Leitungstyp vermittelnden Verunreinigungen ist. Bei einer bevorzugten Ausführungsform des erfindungsgemäßen Verfahrens wird ein N+-dotierter Bereich in einem Substrat vom P-Typ erzeugt. Anschließend wird das gesamte Substrat oxidiert, wobei eine Oxidschicht resultiert, welche über dem N+-dotierten Bereich wesentlich dicker ist als über dem Rest des Substrats. Anschließend werden die dünnen Bereiche der Oxidschicht entweder durch Eintauchen in gepufferte Flußsäure oder mittels eines Trockenätzverfahrens entfernt. Dann erfolgt die Einführung von Verunreinigungen, welche eine Leitfähigkeit vom P-Typ vermitteln, in Bereiche, welche an den N+-dotierten Bereich grenzen. Dabei dient der Rest der dicken Bereiche der Oxidschicht über dem N+-dotierten Bereich als Maske, welche es verhindert, daß die Verunreinigungen, welche P-Leitfähigkeit vermitteln, auch den N+-dotierten Bereich dotieren. Das erfindungsgemäße Verfahren ermöglicht dabei eine sehr genaue Kontrolle der Parameter des P/N-Überganges.

Das erfindungsgemäße Verfahren ist dazu geeignet, dotierte Bereiche zu erzeugen, welche sehr unterschiedliche Funktionen ausführen können. Beispielsweise können mit dem erfindungsgemäßen Verfahren die Subkollektor- und Isolationsbereiche von Bipolartransistoren, die Kollektor- und Basisbereiche von lateralen PNP-Transistoren, Tunneldioden und Transistoren mit einer Tunneldiodencharakteristik erzeugt werden.

Weitere vorteilhafte Ausgestaltungen des erfindungsgemäßen Verfahrens sind den Unteransprüchen zu entnehmen.

Die Erfindung wird anhand von durch Zeichnungen erläuterten Ausführungsbeispielen beschrieben. Es zeigen

Fig. 1A bis 1F im Querschnitt Ausschnitte aus einem Halbleiterbauteil in verschiedenen Stadien seiner Herstellung gemäß dem erfindungsgemäßen Verfahren,

Fig. 2 im Querschnitt einen bipolaren Transistor, dessen Subkollektor- und Isolationsbereiche mittels des erfindungsgemäßen Verfahrens hergestellt worden sind,

Fig. 3A bis 3F im Querschnitt Ausschnitte aus einer Halbleiterstruktur in verschiedenen Stadien der Herstellung eines PNP-Transistors unter Anwendung des erfindungsgemäßen Verfahrens und

Fig. 4A bis 4G im Querschnitt Ausschnitte aus einer Halbleiterstruktur in verschiedenen Stadien der Herstellung eines Transistors, welcher die Eigenschaften einer Tunneldiode hat, wobei das erfindungsgemäße Verfahren angewendet wird.

Das erfindungsgemäße Verfahren zur Herstellung integrierter Schaltungen wird im folgenden anhand der detaillierten Beschreibung einzelner Verfahrensschritte dargelegt. Um die Diskussion zu vereinfachen, werden konventionelle Verfahrensschritte nur kurz beschrieben, während diejenigen Verfahrensschritte, welche die Erfindung ausmachen, genauer besprochen werden.

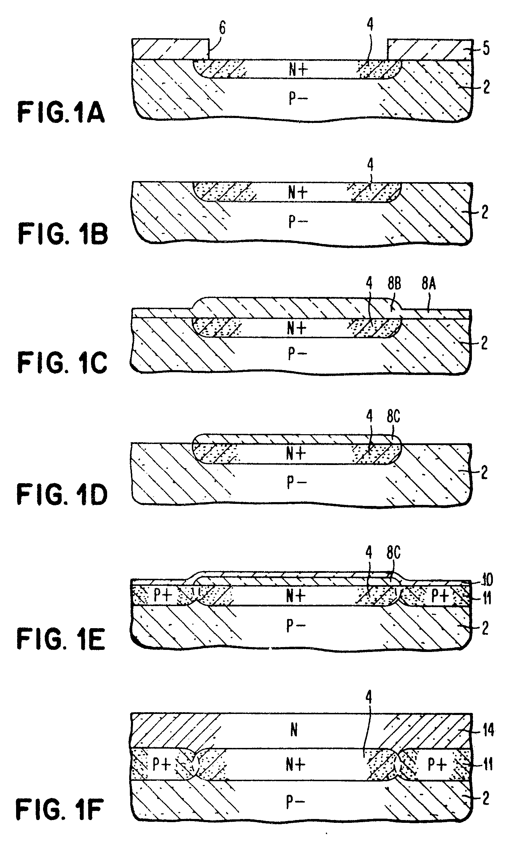

In der Fig. 1A ist eine Struktur gezeigt, welche eine vergrabene N+-dotierte Schicht 4 aufweist. Die Schicht 4 ist in einem Siliciumsubstrat 2 vom P-Typ dadurch erzeugt worden, daß eine Verunreinigung, und zwar bevorzugt Arsen oder Phosphor, in das Substrat durch das Fenster 6 in der Siliciumdioxidmaske 5 eindiffundiert oder implantiert worden ist. Typischerweise hat das Substrat vom P-Typ einen spezifischen Widerstand von ungefähr 10 bis 20 $\Omega$cm und weist eine Oberflächenkonzentration der dotierenden Verunreinigung von ungefähr $7 \times 10^{14}$ Atomen/cm³ auf. Der Subkollektor vom N+-Typ hat eine Oberflächenkonzentration der Verunreinigung, welche größer als ungefähr $10^{20}$ Atomen/cm³ ist. Die Oxidschicht 5 ist ungefähr 300 nm dick, was ausreicht, um das Substrat 2 so gut zu maskieren, daß sowohl Arsen als auch Phosphor in kein Gebiet der Siliciumoberfläche außer denjenigen, welche in den Fenstern 6 der Oxidschicht 5 freiliegen, eindiffundieren kann. Eine (nicht gezeigte) Oxidschicht ist auch auf der Rückseite des Substrats 2 in bekannter Weise vorhanden. In der Fig. 1B ist die Struktur gezeigt, nachdem die Oxidschicht 5 von der oberen Oberfläche des Substrats 2 abgelöst worden ist, wodurch dann die gesamte Oberfläche freiliegt. In dem Verfahrensschritt, welchen die Fig. 1C illustriert, wird die Oberfläche des Substrats 2 reoxidiert, wobei eine Siliciumdioxidschicht gebildet wird, welche aus zwei voneinander verschiedenen Teilbereichen, welche mit den Nummern 8A und 8B versehen sind, besteht. Diese Teilbereiche haben unterschiedliche Dikken, was auf das von Halbleiterfachleuten verstandene Phänomen zurückzuführen ist, daß das Oxid die Neigung hat, über einem hochdotierten Bereich vom N-Typ schneller zu wachsen als über einem Bereich vom N-Typ, welcher nicht so stark dotiert ist, oder als einem Bereich, welcher nur Verunreinigungen enthält, welche eine Leitfähigkeit vom P-Typ hervorrufen. Dieses Phänomen ist beispielsweise in dem Artikel von Chappelow u. a., welcher im IBM Technical Disclosure Bulletin, Band 16, Nr. 5, Oktober 1973, auf den Seiten 1617 und 1617A veröffentlicht ist, beschrieben. Unter Zugrundelegung der oben angegebenen Parameter der dotierten Bereiche ergibt eine 60 Minuten dauernde Oxidation in Wasserdampf bei ungefähr 1000° C eine 250 nm dicke Oxidschicht 8A und eine 500 nm dicke Oxidschicht 8B, was einen Unterschied von 250 nm ergibt. Wird die Oxidationstemperatur erniedrigt, erhöht sich dieser Unterschied. Beispielsweise erhält man bei 800° C ein Differentialverhältnis (differential ratio) von 5 : 1. Auch dieser Faktor ist aus dem Stand der Technik bekannt.

Das Phänomen der unterschiedlichen Schichtdicken tritt unabhängig davon auf, ob der N+-dotierte Bereich 4 mittels der bekannten Diffusionstechniken oder mittels Ionenimplantation erzeugt wird. Darüber hinaus treten die Unterschiede auch zwischen einer Oxidschicht, welche über einem N+-dotierten Bereich aufgewachsen worden ist, und einer Oxidschicht, welche über einem N⁻-dotierten Bereich aufgewachsen worden ist, auf. Das heißt also, daß das erfindungsgemäße Verfahren immer dann anwendbar ist, wenn Bereiche vorhanden sind, welche sich in der Geschwindigkeit, mit der auf ihnen Oxidschichten aufwachsen, unterscheiden.

In der Fig. 1D ist das Ergebnis eines Ätzschrittes abgebildet, bei dem die Oberfläche des Substrats 2 mit der Ausnahme des vom N+-dotierten Bereich 4 belegten Gebietes freigelegt wird. Zum Ätzen wird bevorzugt ein konventionelles Tauchätzverfahren angewandt, bei dem das Substrat so lange in gepufferte Flußsäure getaucht wird, bis die Schicht 8A entfernt ist. Alternativ kann die Oxidschicht auch mittels eines Trockenätzverfahrens, wie z. B. des reaktiven Ionen(Plasma)-Ätzens oder des Kathodenzerstäubungs-Ätzens, weggeätzt werden. Zurück bleibt ein Teil der Schicht 8B, welcher in der Fig. 1D mit der Nummer 8C bezeichnet ist. In den oben beschriebenen speziellen Beispielen hat die Oxidschicht 8C eine Dicke von ungefähr 240 nm. Die Geschwindigkeit, mit der die Schichten 8B und 8A geätzt werden, sind praktisch dieselben, wobei die Schicht 8B um weniger als 10% schneller als die Schicht 8A geätzt wird. Das zurückbleibende Oxid 8C wird durch den Subkollektor 4 definiert.

Diese Ausführungsform des erfindungsgemäßen Verfahrens ist im wesentlichen nach Herstellung der in der Fig. 1E gezeigten Struktur abgeschlossen. Die Fig. 1E zeigt einen P+-dotierten Bereich 11, welcher neben dem N+-dotierten Bereich 4 erzeugt worden ist. Bevorzugt wird dazu eine Schicht 10 aus Borsilicatglas unter Verwendung von BBr$_3$ abgeschieden. Daran schließt sich ein Eintreibungsschritt an, bei welchem sich der P+-dotierte Bereich 11 bildet. Anschließend werden, was nicht gezeigt ist, die Oxidschichten 10 und 8C von der Oberfläche des Substrats 2 abgelöst und zurück bleibt der freigelegte Bereich 4, welcher von dem Bereich 11 umgeben ist.

Es ist auch möglich, den Bereich 11 anstatt mittels Diffusion mittels Ionenimplantation zu erzeugen. Dafür ist eine ausreichend dicke Oxidschicht 8C und eine Implantation mit niedrigen Energien notwendig. Dies ist jedoch mit den heute zur Verfügung stehenden Techniken schwierig zu steuern, was insbesondere dann zutrifft, wenn der Bereich 11 sowohl hochdotiert als auch relativ tief in das Substrat 2 hineinreichen soll.

Eine Methode besteht darin, eine Implantation von Ionen, welche eine Leitfähigkeit vom P-Typ verursachen, nach dem Schritt, dessen Ergebnis in der Fig. 1D gezeigt ist, vorzunehmen. Die Oxidschicht 8C wird dann entfernt, und anschließend wird ein Eintreibschritt durchgeführt, einerseits, um den P+-dotierten Bereich in das Substrat 2 hineinzudiffundieren, und andererseits zum Zwecke des Temperns (annealing).

Ein typisches Chip mit integrierten Schaltkreisen enthält viele Hunderte oder sogar Tausende von N+-dotierten Bereichen, welche von P+-dotierten Bereichen 11 umgeben sind. Diese N+-dotierten Bereiche werden dazu benutzt, um Subkollektorbereiche von bipolaren Transistoren zu bilden, welche von anderen Transistoren, welche auf demselben Chip gebildet worden sind, mittels der P+-dotierten Isolationsbereiche 11 isoliert sind. In der Fig. 1F ist eine Epitaxieschicht 14 gezeigt, welche auf dem Substrat mittels konventioneller Verfahren erzeugt worden ist und für die nachfolgende Bildung von modernen integrierten Schaltungsbauteilen benötigt wird. Ein wesentliches Merkmal des erfindungsgemäßen Verfahrens ist das relativ geringe Überlappen an den Stellen, an denen die Bereiche 4 und 11 aneinanderstoßen. Wegen dieser Eigenschaft ist die Durchbruchsspannung zwischen dem Kollektorbereich 4 und dem Isolationsbereich 11 genau kontrolliert, auch wenn die Bereiche aneinander anstoßen. Wie oben erwähnt wurde, wird dies erreicht, ohne daß eine lithographische Maske notwendig ist, um den Abstand zwischen der Isolation und dem Subkollektor zu definieren.

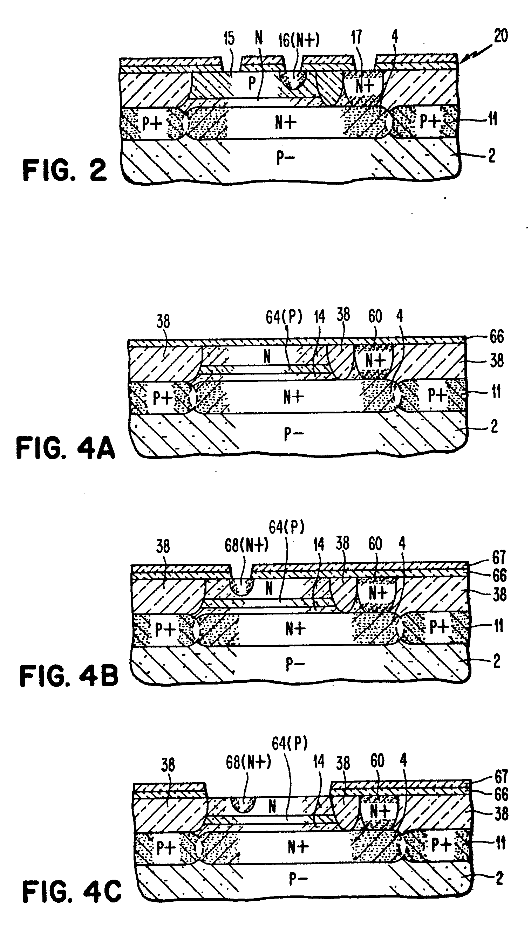

Fig. 2 zeigt eine konventionelle bipolare Transistorstruktur, bei deren Herstellung das erfindungsgemäße Verfahren zum Erzeugen des Subkollektorbereiches 4 und des Isolationsbereiches 11 benutzt wird. Der Transistor wurde in die Zeichnung eingefügt, um die volle Wirkungsweise des erfindungsgemäßen Verfahrens zu zeigen. Zu dem Transistor gehören ein Emitterbereich 16, welcher in dem Basisbereich 15 erzeugt worden ist, und ein Kontakt 17, welcher dazu dient, eine gut leitende Verbindung zum Subkollektor sicherzustellen. Öffnungen sind in der zusammengesetzten Maskenschicht 20 vorhanden, in welchen später leitfähige Dünnfilme abgeschieden werden, welche die Funktion von Kontakten haben. Wie weiter oben erwähnt wurde, ist der Transistor konventionell und Teil des Standes der Technik, und es erscheint deshalb nicht so notwendig bei der Beschreibung mehr ins Detail zu gehen.

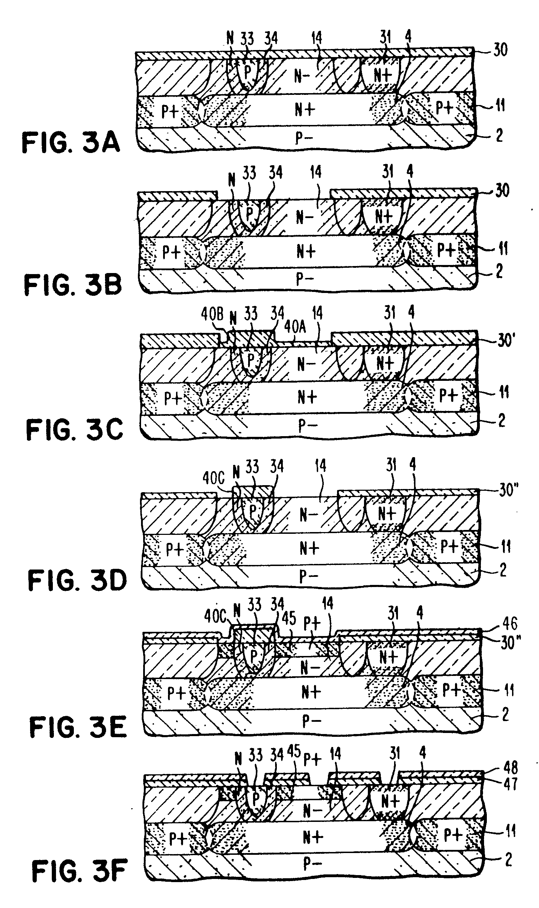

Die Fig. 3A bis 3F sollen die Herstellung eines lateralen PNP-Transistors illustrieren, welcher Basis- und Kollektorbereiche aufweist, welche mittels des erfindungsgemäßen Verfahrens erzeugt worden sind. Die Struktur des dabei im Substrat hergestellten Transistors ist nicht Teil der Erfindung.

In der Fig. 3A ist ein noch nicht fertiger Bipolartransistor gezeigt. Im einzelnen sind das Substrat 2, der Subkollektor 4, der Isolationsbereich 11 vom P+-Typ und die Epitaxieschicht 14 zu sehen. Die genannten Bereiche haben dieselben Eigenschaften und sind in derselben Weise numeriert wie die entsprechenden Bereiche in der Fig. 1F.

Innerhalb des Basisbereiches 34 vom N-Typ befindet sich ein Emitter 33 vom P-Typ, welcher mittels konventioneller Verfahren erzeugt worden ist. Der Basiskontakt 31 vom N+-Typ, welcher auch mittels bekannter Techniken erzeugt worden ist, ist mit dem Basisbereich 34 über den vergrabenen Bereich 4 verbunden, welcher in diesem Fall eher als ein vergrabener Kontakt denn als Subkollektor dient. Auf der Epitaxieschicht 14 ist eine Schicht aus Siliciumdioxid aufgebracht, welche eine Dicke von ungefähr 160 nm hat und üblicherweise thermisch aufgewachsen worden ist. Der Basisbereich 34 enthält bevorzugt Phosphoratome, welche mittels Ionenimplantation in den Epitaxiebereich 14 eingebracht worden sind. Der Emitterbereich 33 ist üblicherweise mit Bor dotiert, wobei das Bor mittels Ionenimplantation in den Basisbereich 34 eingebracht worden ist. Die bevorzugten Verunreinigungskonzentrationen im Emitter- und Basisbereich sind $1 \times 10^{20}$ bzw. $5 \times 10^{18}$ Atome/cm$^3$.

Die Fig. 3B zeigt das Ergebnis eines Verfahrensschrittes, bei dem ein Bereich der Epitaxieschicht 14, welcher den Emitter- und den Basisbereich einschließt, freigelegt worden ist, indem ein Teil der Siliciumdioxidschicht 30 entfernt worden ist. Dies kann mittels eines konventionellen lithographischen Ätzverfahrens erreicht werden.

In dem in der Fig. 3C illustrierten Verfahrensschritt wird die Oberfläche der Epitaxieschicht 14 reoxidiert, wobei eine Siliciumdioxidschicht über dem zuvor freigelegten Bereich der Epitaxieschicht 14 erzeugt wird. Die neu aufgewachsene Oxidschicht besteht aus zwei deutlich voneinander unterschiedenen teilen, welche mit den Nummern 40A und 40B bezeichnet sind. Wie zuvor anhand der Fig. 1C besprochen worden ist, haben die Oxidschichten unterschiedliche Dikken, was darauf zurückzuführen ist, daß das Oxid über hochdotierten Bereichen schneller aufwächst als über Bereichen, welche eine niedrigere Dotierungskonzentration aufweisen.

Wird bei niedrigen Temperaturen im Bereich zwischen 700 und 900° C mit Dampf reoxidiert, so hat die Oxidschicht 40B über dem Emitter- und dem Basisbereich eine Dicke von ungefähr 250 nm, während die Dicke der Oxidschicht 40A über der Epitaxieschicht 14 ungefähr 100 nm beträgt. Die Dicke der Oxidschicht 30 wird bei der Reoxidation auch leicht erhöht und wird deshalb in der Fig. 1C mit der Nummer 30' bezeichnet, jedoch ist dies für die Erfindung ohne Bedeutung. Das Niedertemperatur-Oxidationsverfahren erlaubt die Verwendung von Phosphor als Dotierungsstoff, welcher eine Leitfähigkeit vom N-Typ vermittelt, obwohl Phosphor rasch diffundiert. Allgemein läßt sich sagen, daß das Niedertemperatur-Oxidationsverfahren das Dotierungs- bzw. Verunreinigungsprofil wenig beeinflußt. In der Fig. 3D ist die Struktur gezeigt, nachdem sie — wie oben besprochen — so lange in gepufferte Flußsäure eingetaucht worden ist, bis die Schicht 40A entfernt war. Alternativ kann die Oxidschicht auch mittels reaktiven Ionen(Plasma)- oder mittels Kathodenzerstäubungs-Ätzen entfernt werden. Von der Schicht 40B bleibt dabei ein Teil übrig, welcher in der Fig. 3D mit der Nummer 40C bezeichnet ist. In dem speziellen, oben beschriebenen Beispiel ist die Oxidschicht 40C ungefähr 140 nm dick. Die Oxidschicht 40C ist zum Basisbereich 34 ausgerichtet.

Im nächsten Verfahrensschritt, dessen Ergebnis in der Fig. 3E gezeigt ist, wird der Kollektor 45 des PNP-Transistors in den freiliegenden Bereichen der Epitaxieschicht 14 erzeugt. Wie schon anhand der Fig. 1E weiter oben beschrieben worden ist, wird der Kollektor 45 bevorzugt mittels einer Bordiffusion erzeugt, bei der eine Borsilicatglasschicht 46 aufgebracht und in einem sich anschließenden Eintreibschritt der Bereich 45 vom P+-Typ gebildet wird.

Kontakte zu dem Emitter-, dem Basis- und dem Kollektorbereich 33, 34 bzw. 45 können auf unterschiedliche Art und Weise erzeugt werden.

Zur Herstellung der in der Fig. 3F gezeigten Struktur werden die Oxidschichten 46 und 30'' (die Oxidschicht, welche beim Tauchätzen von der Oxidschicht 30' übrig blieb) und die Oxidschicht 40C vom Substrat abgelöst und statt dessen eine Maskenschicht 47 aus Siliciumdioxid und eine Maskenschicht 48 aus Siliciumnitrid abgeschieden. Diese Verfahrensschritte und auch andere Methoden, um die in der Fig. 3E gezeigte Struktur in die in der Fig. 3F gezeigte Struktur umzuwandeln, sind den Fachleuten wohlbekannt. Dies gilt auch für das sich anschließende Abscheiden von (nicht gezeigtem) leitfähigem Material, welches zur Bildung der ohmschen Kontakte verwendet wird.

Wegen der genauen Ausrichtung der Oxidschicht 40C zum Basisbereich 34 und der daraus resultierenden genauen Ausrichtung der P+-Diffusion zum Basisbereich 34 ist die Konzentration beim Zusammentreffen zwischen den benachbarten, Verunreinigungen enthaltenden Bereichen 45 und 34 genau definiert, ohne daß es nötig wäre, einen photolithographischen Prozeß einzusetzen. Deshalb ist die Basisweite des lateralen PNP-Transistors eng, und zwar typischerweise ungefähr 0,3 µm, wodurch ein Transistor mit hoher Verstärkung und mit einem niedrigen Kollektorserienwiderstand erhalten wird.

Die Fig. 4A bis 4G illustrieren die Herstellung einer Tunneldioden-Transistorstruktur in einem integrierten Schaltkreis unter Verwendung des erfindungsgemäßen Verfahrens. Solch eine Struktur ist in integrierten Schaltungen von Vorteil, weil ihre Schaltungscharakteristik wesentlich schneller ist als diejenige von üblichen Flächendioden (junction diodes), welche in einem Halbleitersubstrat erzeugt worden sind. Die Bauteilstruktur ist nicht Teil der Erfindung; zur Erfindung gehört lediglich das Verfahren zur Herstellung des Tunneldiodenübergangs.

Die Struktur in der Fig. 4A zeigt ein Substrat 2, einen vergrabenen Bereich 4 vom N+-Typ, einen Isolationsbereich 11 vom P+-Typ und eine Epitaxieschicht 14. Alle diese Strukturelemente sind auch schon in der Fig. 1F gezeigt und im Zusammenhang damit auch besprochen worden. Ein eingelegter Oxidisolationsbereich 38 umgibt die aktiven Bereiche des Bauteils und trennt außerdem die Epitaxieschicht 14 von einem Durchreichbereich 60 vom N+-Typ. In einem früherem Verfahrensschritt ist eine dünne Siliciumdioxidschicht 66 mit einer Dicke von ungefähr 160 nm auf der Epitaxieschicht 14 aufgewachsen worden. Dann wurde ein vergrabener Bereich 64 vom P-Typ mittels Ionenimplantation erzeugt, welcher als intrinsische Basis dient. Dieser vergrabene Bereich kann mittels einer typischen Implantation von Borionen mit einer Energie von ungefähr 180 keV und einer Dosis von ungefähr $2,0 \times 10^{13}$ Ionen/cm² durch die Oxidschicht 66 hindurch erzeugt werden. Diese Verfahrensschritte und alternative Methoden, um einen vergrabenen implantierten Bereich zu erzeugen, sind den Halbleiterfachleuten wohlbekannt. Der intrinsische Bereich 64 dient dazu, die Verstärkung des NPN-Transistors, welcher erzeugt werden soll, zu steuern.

Wie die Fig. 4B zeigt, wird dann ein Emitter 68 vom N+-Typ in der Epitaxieschicht 14 oberhalb des Bereiches 64 vom P-Typ erzeugt. Dabei geht man vorteilhafterweise so vor, daß man die Oxidschicht 66 vollständig vom Substrat ablöst, dann eine zusammengesetzte Maskenschicht 66/67 auf dem Substrat aufbringt und anschließend ein Fenster über dem herzustellenden Bereich 68 in dieser zusammengesetzten Maskenschicht erzeugt. Typischerweise besteht die zusammengesetzte Maskenschicht aus einer Siliciumdioxidschicht 66 und einer Siliciumnitridschicht 67. Nach dem Öffnen des Fensters in der zusammengesetzten Maskenschicht kann Arsen zur Bildung des Bereiches 68 entweder eindiffundiert oder implantiert werden. Die Oberflächenkonzentration des Arsens ist ungefähr $3 \times 10^{20}$ Atome/cm³.

Die Fig. 4C zeigt die Struktur, nachdem die zusammengesetzte Maskenschicht 66/67 von einem begrenzten Gebiet auf der Oberfläche der Epitaxieschicht 14 entfernt worden ist. Dies wird mittels bekannter lithographischer Techniken erreicht.

In dem in der Fig. 4D illustrierten Verfahrensschritt wird die Oberfläche der Epitaxieschicht 14 reoxidiert, wobei sich eine Siliciumdioxidschicht bildet, in welcher zwei deutlich voneinander verschiedene Teile zu unterscheiden sind, welche mit den Nummern 70A und 70B bezeichnet sind. Der Schichtteil 70B ist dicker als der Schichtteil 70A, weil der erstere auf dem hochdotierten Bereich 68 vom N+-Typ aufgewachsen worden ist.

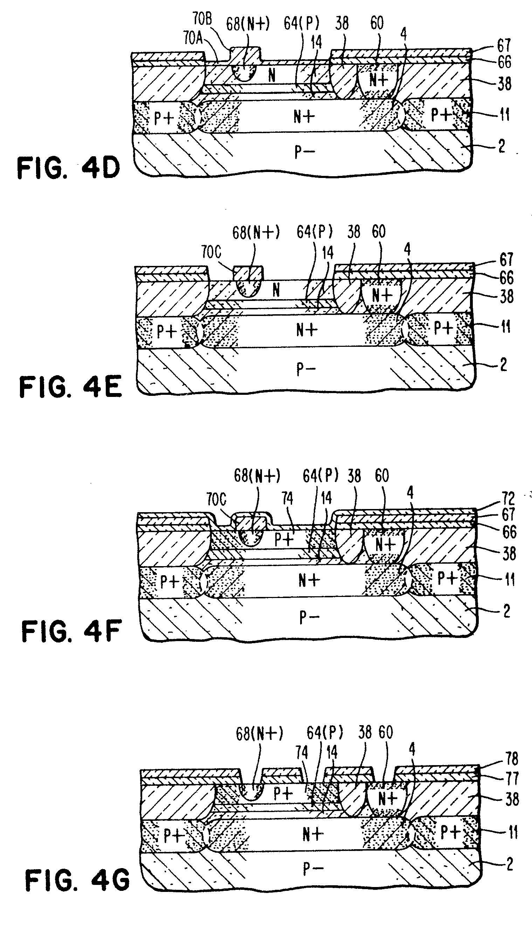

In der Fig. 4E ist das Ergebnis eines Verfahrensschrittes gezeigt, bei dem das in einem vorangegangenen Verfahrensschritt freigelegte Gebiet der Epitaxieschicht 14 teilweise wieder freigelegt wird, indem die Schicht 70A weggeätzt wird. Dazu wird die Struktur so lange in gepufferte Flußsäure eingetaucht, bis die Schicht 70A entfernt ist. Übrig bleibt dann ein Teil der Schicht 70B, welcher in der Fig. 4E mit der Nummer 70C bezeichnet ist.

Als nächstes wird ein extrinsischer Basisbereich 74 vom P+-Typ um den Bereich 68 vom N+-Typ herum erzeugt (Fig. 4F). Der Übergang von den Bereichen 74 vom P+-Typ zu den Bereichen vom N+-Typ ist wegen der Anwendung des erfindungsgemäßen Verfahrens sehr gut definiert.

Die Oberflächenkonzentration des Bereiches 74 vom P+-Typ ist ungefähr $5 \times 10^{19}$ Atome/cm³. Die Emitter-Basis-Bereiche wirken als Tunneldiode, weil die Bereiche auf beiden Seiten des Übergangs entartet dotiert sind und der Schnittpunkt der Dotierungsprofile für eine Tunnelcharakteristik genau gesteuert und optimiert ist.

Um ohmsche Kontakte zu den verschiedenen Bereichen des Transistors, welcher eine Tunneldiodencharakteristik hat, zu erzeugen, werden die Schichten 66, 67 und 72 von der Oberfläche des Substrats weggelöst, und anschließend wird eine neue zusammengesetzte Maskenschicht 77, 78, welche typischerweise aus Siliciumdioxid und Siliciumnitrid besteht, abgeschieden. In diese Maskenschicht werden dann mittels konventioneller lithographischer Techniken die gewünschten Öffnungen für die ohmschen Kontakte geätzt. Die dann vorliegende Struktur ist in der Fig. 4E gezeigt. Die Metallisierung, welche zur Bildung der Kontakte dient, ist den Fachleuten wohlbekannt und deshalb in den Zeichnungen nicht gezeigt.

Zusammenfassend läßt sich sagen, daß mit dem erfindungsgemäßen Verfahren einander benachbarte, dotierte Bereiche in einem Halbleitersubstrat erzeugt werden können. Dabei ist es mit dem erfindungsgemäßen Verfahren möglich, die Konzentration der Verunreinigungen am Schnittpunkt zwischen den beiden benachbarten Bereichen ohne die Anwendung eines lithographischen Prozesses zu definieren. Wie sich aus Zeichnungen ergibt, ist das erfindungsgemäße Verfahren dazu geeignet, verschiedene Typen von Bauteilen und Bereichen in integrierten Schaltungen zu erzeugen.

**Patentansprüche**

1. Verfahren zum Erzeugen in einem Siliciumsubstrat (2) aneinandergrenzender, unterschiedlich dotierter Bereiche, welche Verunreinigungen enthalten, die P- oder N-Leitfähigkeit vermitteln, bei dem zunächst ein erster, höher als das Siliciumsubstrat (2) mit einer den N-Leitungstyp erzeugenden Verunreinigung dotierter Bereich (4; 33, 34; 68) und nachdem der erste Bereich (4; 33, 34: 68) abgedeckt worden ist, der zweite Bereich (11; 45; 74) erzeugt werden, dadurch gekennzeichnet, daß nach Herstellung des ersten Bereiches (4; 33, 34; 68) die Siliciumoberfläche, welche dort, wo sich der erste Bereich (4; 33, 34; 68) befindet und wo der zweite Bereich (11; 45; 74) entstehen soll, vorher freigelegt worden ist, oxidiert wird, wobei über dem erzeugten ersten N-leitenden Bereich (4; 33, 34; 68) ein dickeres Oxid aufwächst als im Gebiet des herzustellenden zweiten Bereiches (11; 45; 74), und daß dann die aufgewachsene Oxidschicht (8A, 8B; 40A, 40B; 70A, 70B) so lange geätzt wird, bis nur noch über dem ersten Bereich (4; 33, 34; 68) Oxid vorhanden ist.

2. Verfahren nach Anspruch 1, dadurch gekennzeichnet, daß in einer Wasserdampfatmosphäre oxidiert wird.

3. Verfahren nach Anspruch 1 oder 2, dadurch gekennzeichnet, daß das Oxid mittels eines Trockenätzverfahrens geätzt wird.

4. Verfahren nach einem oder mehreren der Ansprüche 1 bis 3, dadurch gekennzeichnet, daß der zweite Bereich (11, 45, 74) mittels Diffusion oder mittels Ionenimplantation erzeugt wird.

5. Verfahren nach einem oder mehreren der Ansprüche 1 bis 4, dadurch gekennzeichnet, daß der erste Bereich (34) in einer N⁻-dotierten Epitaxieschicht (14) erzeugt und N-dotiert wird.

6. Verfahren nach einem oder mehreren der Ansprüche 1 bis 4, dadurch gekennzeichnet, daß der erste Bereich (4, 68) N+-dotiert wird.

7. Verfahren nach Anspruch 6, dadurch gekennzeichnet, daß eine Oberflächenkonzentration der N-Leitfähigkeit vermittelnden Verunreinigung von größer ungefähr $10^{20}$ Atomen/cm$^2$ erzeugt wird.

8. Verfahren nach Anspruch 6 oder 7, dadurch gekennzeichnet, daß bei einer Temperatur von ungefähr 1000°C ungefähr eine Stunde bzw. bei einer Temperatur unter 1000°C während einer entsprechend geänderten Zeit oxidiert wird.

9. Verfahren nach einem oder mehreren der Ansprüche 1 bis 4, dadurch gekennzeichnet, daß als erster Bereich in einer N−-dotierten Epitaxieschicht (14) ein N-dotiertes Gebiet (34) mit einem innerhalb desselben befindlichen P+-dotierten Gebiet (33) erzeugt wird.

10. Verfahren nach Anspruch 9, dadurch gekennzeichnet, daß bei einer Temperatur im Bereich zwischen etwa 700 und etwa 900°C oxidiert wird.

11. Verfahren nach Anspruch 6 oder 7, dadurch gekennzeichnet, daß im ersten, N+-dotierten Bereich (68) eine Oberflächenkonzentration von ungefähr $3 \times 10^{20}$ Atomen/cm$^3$ und im zweiten, P+-dotierten Bereich (74) eine Oberflächenkonzentration von ungefähr $5 \times 10^{19}$ Atomen/cm$^3$ erzeugt wird.

12. Verfahren nach einem oder mehreren der Ansprüche 1 bis 11, gekennzeichnet durch seine Verwendung bei der Herstellung von Subkollektor- und Isolationsbereichen (4, 11) von Basis- und Kollektorgebieten (34, 45) lateraler PNP-Transistoren und von Tunneldioden (68, 74).

**Claims**

1. Method of producing in a silicon substrate (2) adjacent differently doped regions with impurities generating P or N type conductivities, wherein initially a first region (4; 33, 34; 68), doped more highly than the silicon substrate (2) with an impurity generating an N type conductivity, and subsequently the second region (11; 45; 74) are generated, characterized in that after production of the first region (4; 33, 34; 68), the silicon surface is oxidized after having been previously bared in the area of the first region (4; 33, 34; 68) and in the area in which the second region (11; 45; 74) is to be produced, growing on the first N type region produced (4; 33, 34; 68) a thicker oxide than in the area of the second region to be produced (11; 45; 74), and that the grown oxide layer (8A, 8B; 40A, 40B; 70A, 70B) is subsequently etched until oxide exists only over the first region (4; 33, 34; 68).

2. Method according to claim 1, characterized in that oxidation is accomplished in a water vapor atmosphere.

3. Method according to claim 1 or 2, characterized in that etching of the oxide is accomplished by dry etching.

4. Method according to any one or several of the claims 1 to 3, characterized in that the second region (11, 45, 74) is produced by diffusion or ion implantation.

5. Method according to any one or several of the claims 1 to 4, characterized in that the first region (34) is produced in an N− doped epitaxial layer (14) and N doped.

6. Method according to any one or several of the claims 1 to 4, characterized in that the first region (4, 68) is N+ doped.

7. Method according to claim 6, characterized in that a surface concentration of greater than around $10^{20}$ atoms/cm$^2$ is produced.

8. Method according to claim 6 or 7, characterized in that oxidation is accomplished at a temperature of around 1000°C for around one hour or at a temperature below 1000°C for a suitably changed time.

9. Method according to any one or several of the claims 1 to 4, characterized in that an N doped region (34) with a P+ doped region (33) contained therein is produced as a first region in an N− doped epitaxial layer (14).

10. Method according to claim 9, characterized in that oxidation is accomplished at a temperature in the range between around 700 and around 900°C.

11. Method according to claim 6 or 7, characterized in that a surface concentration of around $3 \times 10^{20}$ atoms/cm$^3$ is generated in the N+ doped region (68) and a surface concentration of around $5 \times 10^{19}$ atoms/cm$^3$ in the P+ doped region (74).

12. Method according to any one or several of the claims 1 to 11, characterized in that it is used for producing subcollector and isolation regions (4, 11), base and collector regions (34, 45), lateral PNP transistors, and tunnel diodes (68, 74).

**Revendications**

1. Procédé permettant de produire dans un substrat de silicium (2) des zones voisines différemment dopées, contenant des impuretés qui procurent une conductivité de type N ou P, en créant d'abord une zone (4; 33, 34; 68) dopée par une impureté produisant une conductivité de type N, le dopage étant plus fort que celui du substrat de silicium (2), et en recouvrant ensuite la première zone (4; 33, 34; 68) pour produire la seconde zone (11; 45; 74), caractérisé par le fait que après la production de la première zone (4; 33, 34; 68), la surface de silicium, après avoir été dégagée à l'endroit où se trouve la première zone (4, 33, 34; 68) et où devra être établie la seconde zone (11; 45; 74), est oxydée, de manière à ce que dans la première zone de conductivité de type N (4; 33, 34; 68), une couche d'oxyde se constitue plus épaisse que dans la région de la seconde zone (11; 45; 74), et que la couche d'oxyde (8A, 8B; 40A, 40B; 70A, 70B) est ensuite décapée jusqu'à ce que l'oxyde subsiste seulement sur la première zone (4; 33, 34; 68).

2. Procédé selon la revendication 1, caractérisé par le fait que l'oxydation est obtenue dans une atmosphère de vapeur d'eau.

3. Procédé selon les revendications 1 ou 2, caractérisé par le fait que l'oxyde est décapé par un procédé de décapage à sec.

4. Procédé selon une ou plusieurs des revendications 1 à 3, caractérisé par le fait que la seconde zone (11, 45, 74) est produite par diffusion ou par implantation d'ions.

5. Procédé selon une ou plusieurs des revendications 1 à 4, caractérisé par le fait que la première zone (34) est créée dans une couche épitaxiale de type N⁻ (14) et qu'elle est de type N.

6. Procédé selon une ou plusieurs des revendications 1 à 4, caractérisé par le fait que la première zone (4, 68) est de type N⁺.

7. Procédé selon la revendication 6, caractérisé par le fait qu'une concentration de surface (de l'impureté provoquant la conductivité de type N) contenant plus de $10^{20}$ atomes/cm$^2$ (environ) est créée.

8. Procédé selon la revendication 6 ou 7, caractérisé par le fait que l'oxydation est obtenue à une température de 1000° C environ, maintenue pendant une heure, ou à une température inférieure à 1000°C dont la durée est modifiée en conséquence.

9. Procédé selon une ou plusieurs des revendications 1 à 4, caractérisé par le fait que la première zone créée est une région à dopage de type N (34), à l'intérieur d'une couche épitaxique (14) à dopage de type N⁻, une zone (33) à dopage de type P⁺ se trouvant à l'intérieur de la région (34).

10. Procédé selon la revendication 9, caractérisé par le fait que l'oxydation est obtenue à une température comprise entre environ 700 et 900°C.

11. Procédé selon les revendications 6 ou 7, caractérisé par le fait que dans la première zone à dopage de type N⁺ (68), la une concentration de surface est d'environ $3 \times 10^{20}$ atomes/cm$^3$, et dans la seconde zone à dopage de type P⁺ (74), la concentration de surface est d'environ $5 \times 10^{19}$ atomes/cm$^3$.

12. Procédé selon une ou plusieurs des revendications 1 à 11, caractérisé par son emploi pour la fabrication de zones de sous-collecteurs et d'isolation (4, 11), de zones de bases et de collecteurs (34, 45), de transistors latéraux de type PNP et de diodes à tunnel (68, 74).

FIG. 1A

FIG. 1B

FIG. 1C

FIG. 1D

FIG. 1E

FIG. 1F

**FIG. 2**

**FIG. 4A**

**FIG. 4B**

**FIG. 4C**

FIG. 3A

FIG. 3B

FIG. 3C

FIG. 3D

FIG. 3E

FIG. 3F

FIG. 4D

FIG. 4E

FIG. 4F

FIG. 4G